# EUROPÄISCHE PATENTSCHRIFT

(11) **EP 3 327 357 B1**
(45) Veröffentlichungstag und Bekanntmachung des Hinweises auf die Patenterteilung: **06.04.2022**
(21) Anmeldenummer: 17202226.1
(22) Anmeldetag: 17.11.2017
(51) Int. Cl.: F24C 7/08

(54) **KOCHFELD MIT BEDIENEINRICHTUNG**
COOKTOP WITH OPERATING DEVICE
PLAQUE DE CUISSON AVEC DISPOSITIF DE COMMANDE

(30) Priorität: 23.11.2016 DE 102016223184
(43) Veröffentlichungstag der Anmeldung: 30.05.2018
(73) Patentinhaber: E.G.O. Elektro-Gerätebau GmbH, 75038 Oberderdingen (DE)
(72) Erfinder: Fix, Thorsten, 75177 Pforzheim (DE); Kern, Fabian, 75173 Pforzheim (DE)
(74) Vertreter: Patentanwälte Ruff, Wilhelm, Beier, Dauster & Partner mbB

(56) Entgegenhaltungen:
- EP-A1- 0 759 660
- EP-A1- 0 766 887
- EP-A2- 1 933 462
- DE-C1- 19 700 836

## Beschreibung

Die Erfindung betrifft ein Kochfeld mit einer Bedieneinrichtung.

Aus der EP 2251762 A2 ist eine Bedieneinrichtung für ein Kochfeld bekannt, bei der oberhalb einer Bedienblende ein abnehmbar und bewegbar ausgestalteter Dreh- oder Schieberegler aufgesetzt ist. Er ist sozusagen magnetisch gelagert für eine besonders vorteilhafte Drehbarkeit, wie sie aus der EP 1775650 A2 bekannt ist. Er kann an seiner Oberseite einen kapazitiven Berührungsschalter aufweisen zur Signalübermittlung an eine Sensorik und Steuerung innerhalb der Bedienblende. Des Weiteren kann er zumindest teilweise lichtdurchlässig sein, um durch die Bedienblende hindurch Licht hineinzustrahlen, so dass es an der Oberseite zur Beleuchtung bzw. Kennzeichnung von Bedienfunktionen sichtbar ist. Problematisch hierbei ist es aber, dass an den Schichtübergängen bzw. Materialübergängen eine Totalreflexion auftritt, was zu störenden Auswirkungen führen kann.

Aus der DE 19 700 836 C1 ist eine Bedieneinrichtung für ein Elektrogerät bekannt, die als Reflex-Lichtschranke ausgebildet ist mit einer optischen Sendeeinrichtung und einer optischen Empfangseinrichtung für Lichtstrahlen. Die beiden Einrichtungen sind in einem Gehäuse angeordnet mit geringem Abstand zu einer Bedienblende. Wird ein Finger einer Bedienperson oberhalb der Einrichtungen auf die Bedienblende aufgelegt, so wird ein Lichtstrahl von der Sendeeinrichtung zur Empfangseinrichtung reflektiert, was erkannt und als Bedienung ausgewertet wird.

Aus der EP 1 933 462 A2 ist eine weitere konstruktiv sehr ähnliche Bedieneinrichtung bekannt, die ebenfalls als Reflex-Lichtschranke ausgebildet ist. Hier wird ein Lichtstrahl von der Sendeeinrichtung bereits schräg nach oben gestrahlt in Richtung zu einem Punkt oberhalb der Empfangseinrichtung. Für einen durch den aufgelegten Finger einer Bedienperson durch die Bedienblende hindurch reflektierten Lichtstrahl ist oberhalb der Empfangseinrichtung ebenfalls eine schräge Fläche vorgesehen. Dadurch kann die Funktion der Reflex-Lichtschranke der Bedieneinrichtung verbessert werden.

Aus der EP 759 660 A1 ist eine nochmals weitere Bedieneinrichtung mit einer Reflex-Lichtschranke bekannt. Hier sind mehrere Lichtsender und ein einziger Lichtempfänger vorgesehen, wobei die Lichtsender im Multiplexbetrieb angesteuert werden. Auch hier wird Licht durch einen auf eine Bedienblende aufgelegten Finger einer Bedienperson von einem der Lichtsender zu dem Lichtempfänger reflektiert.

Aus der EP 0 766 887 A1 ist eine Bedieneinrichtung bekannt, die keinen spezifischen Verwendungszweck hat, mit der aber auch Elektrogeräte bedient werden können. Unterhalb einer Bedienblende ist ein Lichtsender vorgesehen, dessen ausgestrahltes Licht durch eine erste Anordnung von Linsen verläuft, wodurch das Licht kollimiert wird. Das kollimierte Licht geht zu einer weiteren Anordnung von Linsen, welche das Licht wiederum bündelt bzw. fokussiert. Dieses gebündelte bzw. fokussierte Licht geht durch eine Bedienblende und kann durch Auflegen eines Fingers einer Bedienperson auf diese Bedienblende zurückreflektiert werden. Das zurückreflektierte Licht geht durch dieselbe Anordnung von Linsen hindurch, wird also zuerst unterhalb der Bedienblende kollimiert. Die kollimierten Lichtstrahlen gehen dann durch eine weitere Anordnung von Linsen und werden auf einen Lichtempfänger gebündelt, damit dieser eine maximale Lichtausbeute hat.

### Aufgabe und Lösung

Der Erfindung liegt die Aufgabe zugrunde, ein eingangs genanntes Kochfeld zu schaffen, mit dem es möglich ist, eine genauere und besser auswertbare Lichtführung für ein optisches Bedienelemente einem Bedieneinrichtung des Kochfelds zu erreichen, die weitgehend störungsunanfällig ist.

Gelöst wird diese Aufgabe durch ein Kochfeld mit den Merkmalen des Anspruchs 1. Vorteilhafte sowie bevorzugte Ausgestaltungen der Erfindung sind Gegenstand der weiteren Ansprüche und werden im Folgenden näher erläutert. Dabei werden mache der Merkmale nur für die Bedieneinrichtung oder nur für das Kochfeld beschrieben. Sie sollen jedoch unabhängig davon für das Kochfeld gelten können. Der Wortlaut der Ansprüche wird durch ausdrückliche Bezugnahme zum Inhalt der Beschreibung gemacht.

Es ist vorgesehen, dass die Bedieneinrichtung eine Bedienblende aufweist, die unter Umständen auch eine Vorderseite oder Oberseite des gesamten Kochfelds sein kann. Bei dem Kochfeld ist die Kochfeldplatte die Bedienblende für die Bedieneinrichtung, so dass die Bedieneinrichtung vollständig in das Gerät integriert ist. Oberhalb der Bedienblende erfolgt die Bedienung des Kochfelds durch eine Bedienperson, insbesondere durch Auflegen eines Fingers auf ein erfindungsgemäßes Bedienelement, und/oder Bewegen eines erfindungsgemäßen Bedienelements. Unterhalb der Bedienblende kann vorteilhaft eine Steuerung für die Bedieneinrichtung vorgesehen sein, welche für die Bedieneinrichtung alleine oder auch für das gesamte Kochfeld vorgesehen sein kann. Des Weiteren ist eine optische Sendeeinrichtung für Lichtstrahlen sowie eine optische Empfangseinrichtung für Lichtstrahlen vorgesehen. Des Weiteren sind optische Umlenkmittel für die Lichtstrahlen zwischen der Unterseite der Bedienblende und der Sendeeinrichtung und/oder der Empfangseinrichtung vorgesehen. Die Lichtstrahlen der Sendeeinrichtung werden dabei oberhalb von der Bedienblende durch eine entsprechende Bedienung durch die Bedienperson reflektiert, beispielsweise bei einem Funktionsprinzip einer Reflex-Lichtschranke durch Auflegen eines Fingers auf eine bestimmte Stelle auf einem vorgenannten Bedienelement auf der Bedienblende. Diese Reflexion erfolgt mit einem Lichtweg der reflektierten Lichtstrahlen, der erneut von oben nach unten durch die Bedienblende geht und hin zu der Empfangseinrichtung führt. Die vorgenannte Reflex-Lichtschranke besteht demzufolge durch die Bedienblende hindurch bzw. die Reflexion durch Bedienung findet oberhalb der Bedienblende statt, der Lichtweg geht also zweimal durch die Bedienblende.

Erfindungsgemäß sind unterhalb der Unterseite der Bedienblende als optische Umlenkmittel Mittel zur Kollimierung von Lichtstrahlen angeordnet. Die Mittel zur Kollimierung von Lichtstrahlen richten die Lichtstrahlen weitgehend parallel. Ein Winkelfilter lässt nur Lichtstrahlen durch, die in einem bestimmten Winkel auf ihn auftreffen, vorteilhaft gerade die parallel gerichteten. Optional können noch Mittel zum Schrägstellen bzw. schrägen Reflektieren der Lichtstrahlen in einem Winkelbereich zwischen 50° und 80° zur Ebene der Unterseite der Bedienblende vorgesehen sein. Dieser Winkel richtet sich nach dem Gesamtaufbau des Systems und wird so gewählt, dass an den Phasenübergängen reflektiertes Licht nicht auf den Empfänger fällt. So können die von der optischen Sendeeinrichtung ausgesandten Lichtstrahlen möglichst gut ausgerichtet und/oder geformt werden, damit eine Bedienung nach Art einer Reflex-Lichtschranke oberhalb der Bedienblende möglichst gut und sicher erkannt werden kann.

Unter Umständen kann in einer vorteilhaften Ausgestaltung der Erfindung vorgesehen sein, dass die Mittel zur Kollimierung der Lichtstrahlen sowie die Mittel zum Schrägstellen bzw. schrägen Reflektieren dieselben sind. Sie können auch Teil der vorgenannten optischen Umlenkmittel sein. Vorteilhaft sind es jedoch unterschiedliche Mittel, die dann entsprechend individuell und gut an ihre jeweilige Funktion angepasst werden können.

Für das Schrägstellen bzw. schräge Reflektieren der Lichtstrahlen können verschiedene Mittel vorgesehen sein. Vorteilhaft können dies ein Spiegel bzw. Reflektor, eine seitlich versetzte Linse oder sogar eine sogenannte Fresnel-Linse in schräger Anordnung zur Unterseite der Bedienblende sein. Ebenso können Prisma oder Lichtleiter verwendet werden. Es können auch mehrere dieser Mittel bzw. vor allem mehrere Reflektoren vorgesehen sein, beispielsweise zwei Reflektoren. Hier können sowohl ebene bzw. plane als auch gewölbte oder sphärische Reflektoren vorgesehen sein, abhängig von der jeweils gewünschten bzw. notwendigen Funktion.

Ein sogenannter Winkelfilter lässt nur Lichtstrahlen durch, die in einem bestimmten Winkel auf ihn auftreffen, so dass nur zumindest weitgehend paralleles bzw. gleichgerichtetes Licht aus ihm heraustreten kann. Vorteilhaft liegen die Lichtstrahlen in einem Öffnungswinkel bzw. einem Winkelbereich von etwa 30°, besonders vorteilhaft unter 20°. Ein solcher Winkelfilter kann beispielsweise eine Wabenstruktur aufweisen, also eine sehr große Anzahl von parallelen länglichen Durchbrüchen oder Bohrungen aufweisen, die nur zumindest weitgehend parallele Lichtanteile hindurchlassen.

Im Lichtweg hinter und konstruktiv oberhalb von der Sendeeinrichtung hin zur Unterseite der Bedienblende kann in vorteilhafter Ausgestaltung der Erfindung ein gewölbter oder sphärischer Reflektor als Mittel zur Kollimierung der Lichtstrahlen vorgesehen sein, der ausgesandte und auf den Reflektor auftreffende Lichtstrahlen spiegelt und bündelt. Hier kann unter Umständen auch eine vorgenannte Fresnel-Linse verwendet werden, für die allerdings das Licht bereits zumindest teilweise gleichgerichtet werden sollte. Wenn der Strahler bzw. die Sendeeinrichtung im Brennpunkt der Linse sitzt können auch die kollimierenden Eigenschaften der Fresnel-Linse verwendet werden ohne vorherige Gleichrichtung.

Eine optische Sendeeinrichtung, welche allgemein vorteilhaft eine LED ist, kann so ausgebildet sein, dass sie eben hauptsächlich nach oben, also zur Unterseite der Bedienblende hin, Lichtstrahlen aussendet. Somit wird ein Großteil, unter Umständen auch alles, der ausgesandten Lichtstrahlen zuerst einmal von diesem sphärischen Reflektor als Mittel zur Kollimierung umgelenkt und gebündelt. Unterhalb von der Sendeeinrichtung, also in einer Richtung weg von der Bedienblende, kann ein ebener Reflektor vorgesehen sein, um auftreffende Lichtstrahlen zu spiegeln. Oberhalb der Sendeeinrichtung sind vorteilhaft die vorgenannten Mittel zur Kollimierung von Lichtstrahlen vorgesehen, und dahinter vorzugsweise ein vorgenannter Winkelfilter. Die Lichtstrahlen, die von der Sendeeinrichtung direkt zu den Mitteln zur Kollimierung gesandt werden, gehen danach über den ebenen Reflektor hin zu dem Winkelfilter

Ein gewölbter Reflektor als Mittel zur Kollimierung kann rinnenartig ausgebildet sein, also mit Wölbung in einer Richtung und beispielsweise länglich mit gleichbleibender Wölbung. Alternativ kann er teilkugelartig ausgebildet sein mit Wölbung in zwei Richtungen, eben sphärisch. Im Folgenden werden mit dem Ausdruck gewölbter Reflektor beide Ausführungen zusammen beschrieben.

In Ausgestaltung der Erfindung kann vorgesehen sein, dass ein Teil der von der Sendeeinrichtung ausgesandten Lichtstrahlen direkt auf den Winkelfilter trifft, also ohne von den Mitteln zur Kollimierung bzw. einem der Reflektoren gespiegelt zu werden. Im Lichtweg hinter dem Winkelfilter kommt dann die Bedienblende bzw. deren Unterseite.

Es ist leicht vorstellbar, dass die vorgenannten Mittel und Reflektoren in dieser Form nicht nur an bzw. hinter der Sendeeinrichtung vorgesehen sein können, sondern auch an bzw. vor der Empfangseinrichtung. Der Lichtweg ist dann eben genau andersherum, geht also nach dem Zurückstrahlen durch die Bedienblende zuerst durch den Winkelfilter und dann durch die Mittel zur Kollimierung. Alternativ kann das Licht dann zum Teil direkt auf die Empfangseinrichtung treffen, zum größeren Teil über den gewölbten Reflektor und zum Teil zuerst über den ebenen Reflektor und dann über den gewölbten Reflektor auf die Empfangseinrichtung. So wird dann ein möglichst großer Anteil der zurückreflektierten und kollimierten Lichtstrahlen zur Empfangseinrichtung geleitet, damit diese eine mögliche Bedienung durch die Bedienperson möglichst gut erfassen kann. Unter Umständen kann eine derartige Führung der Lichtstrahlen mit optischen Mitteln sowohl an der Sendeeinrichtung als auch an der Empfangseinrichtung vorgesehen sein, dann aber natürlich getrennt voneinander. Allerdings wird hier der Aufwand dann sehr hoch. Aufgrund des Intensitätsunterschieds des Lichts abgehend von der Sendeeinrichtung und ankommend an der Empfangseinrichtung wird es als vorteilhaft angesehen, die von der Sendeeinrichtung kommenden Lichtstrahlen zuerst speziell schrägzustellen und dabei zu kollimieren und danach erst durch den Winkelfilter zu schicken. Dann gehen die Lichtstrahlen durch die Bedienblende zur Bedienung darüber. Die bei einer Bedienung zurückreflektierten Lichtstrahlen werden dann direkt an die Empfangseinrichtung geleitet, unter Umständen noch mit einer Linse oder anderen Mitteln zur Bündelung von Lichtstrahlen auf die Empfangseinrichtung, welche aber sehr einfach ausgestaltet und angeordnet sein können.

Die Mittel zur Kollimierung der Lichtstrahlen können also im Weg der Lichtstrahlen nach der Sendeeinrichtung als gewölbter Reflektor und vor dem ebenen Reflektor angeordnet sein. Alternativ können sie im Weg der Lichtstrahlen vor dem gewölbten Reflektor, dem ebenen Reflektor und der Empfangseinrichtung angeordnet sein. Die Mittel können beispielsweise an einem Gehäuse einer Sendeeinrichtung oder einer Empfangseinrichtung derart vorgesehen sein, dass sie eine seitliche Außenwandung oder eine Oberseite bilden.

Es ist also möglich, dass die optischen Mittel für die Sendeeinrichtung gleichartig, insbesondere weitgehend identisch, ausgebildet sind wie die optischen Mittel für die Empfangseinrichtung.

Der Winkelfilter für die kollimierten Lichtstrahlen kann im Weg der Lichtstrahlen nach der Sendeeinrichtung und den Mitteln zu Kollimierung angeordnet sein. Alternativ kann er im Weg der reflektierten Lichtstrahlen vor dem ebenen Reflektor, dem gewölbten Reflektor und der Empfangseinrichtung angeordnet sein. Die Mittel können beispielsweise an einem Gehäuse einer Sendeeinrichtung oder einer Empfangseinrichtung derart vorgesehen sein, dass sie eine seitliche Außenwandung oder eine Oberseite bilden.

In vorteilhafter Ausgestaltung der Erfindung werden oberhalb der Unterseite der Bedienblende bzw. oberhalb der Bedienblende keine besonderen Mittel zur Umformung oder Reflexion der Lichtstrahlen vorgesehen, sie strahlen also einfach durch die lichtdurchlässige Bedienblende hindurch. Oberhalb der Bedienblende ein eingangs genanntes Bedienelement vorgesehen, das auch bewegbar sein kann, um Licht zurückzureflektieren für die Reflex-Lichtschranke. Das Bedienelement kann mindestens eine Stelle, vorteilhaft auch mehrere, aufweisen als eine Art Berührungssensor, an der die ausgesandten Lichtstrahlen herausstrahlen bzw. hindurchstrahlen. So kann durch Auflegen eines Fingers auf diese Stelle eine Bedienung erfolgen, da die Empfangseinrichtung dann das zurück nach unten reflektierte Licht erfassen kann. Ein solches Bedienelement kann vorteilhaft flach sein, beispielsweise scheibenartig. Es kann bewegbar, insbesondere drehbar, auf der Bedienblende gelagert sein, beispielsweise magnetisch oder mechanisch. Es kann abnehmbar ausgebildet sein. Die Lichtstrahlen können durch optische Kanäle in dem Bedienelement hindurchgehen, die von einer Unterseite des Bedienelements zu einer Oberseite führen, unter Umständen auch zu einer lateralen Außenseite. Vorteilhaft können hier Lichtleiter oder zumindest lichtdurchlässige Fenster zum Verschließen von Durchbrüchen oder Kanälen vorgesehen sein.

In Ausgestaltung der Erfindung kann der genannte ebene Reflektor in einem spitzen Winkel zu den Mitteln zur Kollimierung stehen, beispielsweise in einem Winkel zwischen 45° und 80°. Besonders vorteilhaft kann dieser Winkel zwischen 55° und 70° liegen.

In weiterer Ausgestaltung der Erfindung kann der ebene Reflektor an die Mittel zur Kollimierung nahe heranreichen, so dass der Abstand sehr gering ist, oder die beiden können sich sogar berühren. So können möglichst viele Lichtstrahlen vom Reflektor durch die Mittel zur Kollimierung verlaufen.

In einer Ausbildung der Erfindung kann eine in radialer Richtung verlaufende Mittelsenkrechte des gewölbten Reflektors bzw. der Mittel zur Kollimierung in etwa parallel zu dem Winkelfilter bzw. dessen Erstreckungsebene verlaufen. Eine Winkelabweichung kann bevorzugt maximal zwischen 5° und 10° betragen, besonders bevorzugt ist sie genau Null. Zusammen mit einer vorgenannten Winkelbedingung zwischen dem ebenen Reflektor und dem Winkelfilter ergibt sich dadurch auch eine Winkelbeziehung zwischen dem gewölbten Reflektor bzw. seiner Mittelsenkrechten und dem ebenen Reflektor, da bevorzugt das Licht von dem gewölbten Reflektor immer zuerst auf den ebenen Reflektor umgelenkt wird, um erst von dort durch den Winkelfilter zu verlaufen.

Auch der gewölbte Reflektor als Mittel zur Kollimierung kann mit einem Rand sehr nahe an den Winkelfilter heranreichen, unter Umständen sogar daran anstoßen. Dieser Winkel beim direkten Anstoßen kann zwischen 100° und 130° liegen.

Der gewölbte Reflektor kann vor allem in einer Ausbildung als konvexer Reflektor dazu dienen, die von der Sendeeinrichtung als Kugelstrahler ausgesandten Lichtstrahlen, die nicht direkt auf den Winkelfilter treffen oder direkt auf den ebenen Reflektor treffen, schon etwas gleichgerichtet auf diesen ebenen Reflektor zu spiegeln. Dieser spiegelt sie dann wiederum auf den Winkelfilter. Besonders vorteilhaft trifft eigentlich kein Licht direkt von der Sendeeinrichtung auf den ebenen Reflektor, da die Sendeeinrichtung üblicherweise als LED so ausgebildet ist, dass sie maximal nach oben strahlt.

Das erfindungsgemäße Kochfeld weist die erfindungsgemäße Bedieneinrichtung auf. Eine Steuerung für die Bedieneinrichtung, insbesondere eine Ansteuerung für die Sendeeinrichtung und eine Auswertung der Empfangseinrichtung, kann separat für die Bedieneinrichtung vorgesehen sein, vorteilhaft aber vom Kochfeld selbst bzw. von dessen Zentralsteuerung übernommen werden. Gerade für vorbeschriebene Bedienelemente in Form von magnetisch gehaltenen und zentrierten, abnehmbaren Bedienelementen als Drehknebel und/oder Schiebeknebel wird eine Oberseite des Kochfelds als vorteilhaft angesehen, da hier die Halterung bzw. Lagerung besser möglich ist. Bei dem Kochfeld bildet eine Kochfeldplatte direkt einen Teil der Bedienblende, wie dies aus dem Stand der Technik ja bekannt ist. Auch dunkel rotbraun eingefärbte Glaskeramik-Kochfeldplatten weisen eine gewisse Lichtdurchlässigkeit auf, die hier ausreichen kann, wenn das Licht der Sendeeinrichtung entsprechend ist bzw. eine entsprechende Wellenlänge aufweist. Vorteilhaft wird ohnehin IR-Licht bzw. nicht sichtbares Licht verwendet, um eine Bedienperson nicht zu stören.

Auf einer Oberseite eines solchen Bedienelements können mehrere Markierungen vorgesehen sein, wobei das Auflegen eines Fingers darauf dann ein Reflektieren der Lichtstrahlen der Sendeeinrichtung an die zugehörige Empfangseinrichtung bewirkt und somit eine Bedienung. Im Prinzip kann die Erfindung also bei einer Bedieneinrichtung verwendet werden, wie sie aus der eingangs genannten EP 2251762 A2 bekannt ist, nur dass eben die Lichtführung unterhalb der Bedienblende nun erfindungsgemäß verbessert ist. Dies führt zu einer erheblich besser auswertbaren Bedieneinrichtung mit höherer Störsicherheit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine vereinfachte seitliche Schnittdarstellung durch ein Kochfeld mit einer erfindungsgemäßen Bedieneinrichtung mit schräggestellten Lichtstrahlen von einem Sender und
- Fig. 2: eine vergrößerte Schnittdarstellung durch einen Sender einer erfindungsgemäßen Bedieneinrichtung mit gewölbtem Reflektor, ebenem Reflektor und einem Winkelfilter mit Wabenstruktur.

### Detaillierte Beschreibung der Ausführungsbeispiele

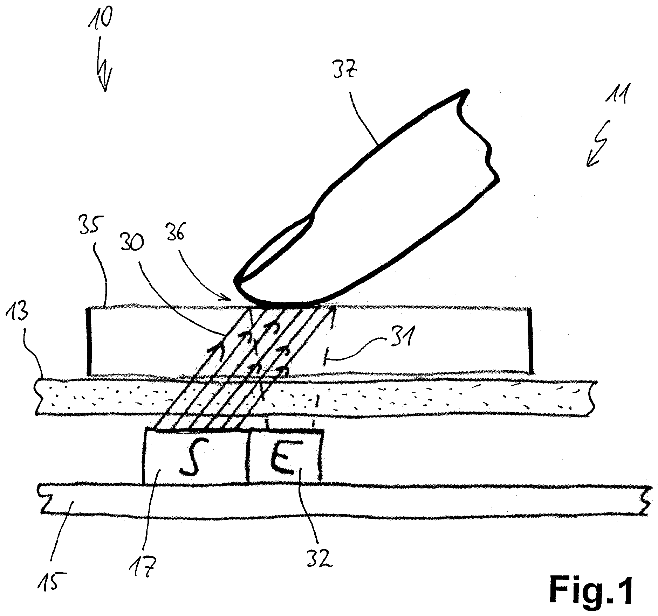

In der Fig. 1 ist ein erfindungsgemäßes Kochfeld 10 dargestellt im seitlichen Schnitt mit einer integrierten erfindungsgemäßen Bedieneinrichtung 11. Zur Bedienung weist die Bedieneinrichtung 11 ein aufgesetztes Bedienelement 35 auf, wie es grundsätzlich aus der eingangs genannten EP 2251762 A2 bekannt ist. Es ist auf nicht dargestellte Art und Weise magnetisch gelagert, insbesondere zumindest drehbeweglich. Eine Drehbewegung kann sensorisch, entweder über Magnetfeldsensoren oder optische Sensoren, erfasst und in Bedienbefehle umgesetzt werden. So kann beispielsweise eine Leistungseinstellung einer Kochstelle des Kochfelds 10 erfolgen. Eine Bedienung kann hier sogar ohne aufgesetztes Bedienelement 35 erfolgen, nur mit Auflegen eines Fingers.

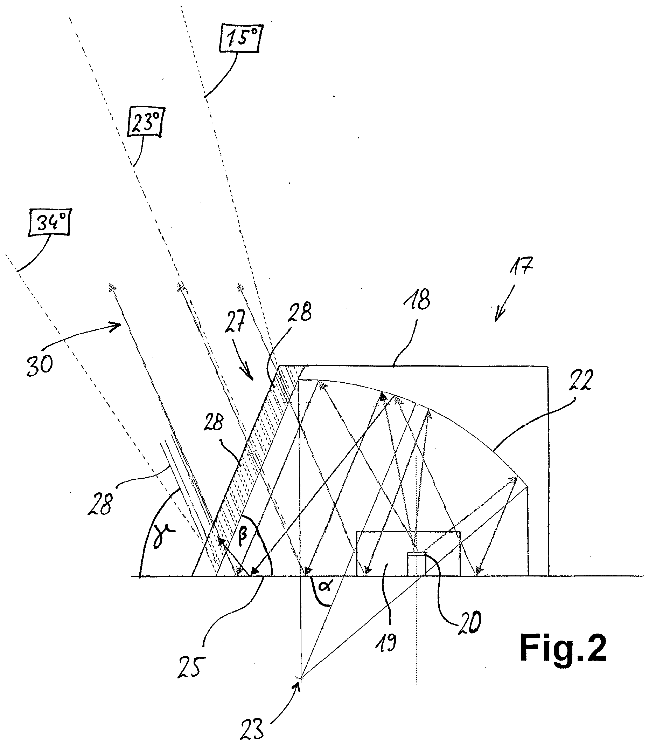

Unter einer Kochfeldplatte 13, die erfindungsgemäß hier die Funktion einer Bedienblende übernimmt bzw. eine solche bildet, ist eine Leiterplatte 15 mit einem Sender 17 und einem Empfänger 32 angeordnet. Diese beiden Teile können direkt nebeneinander angeordnet sein, müssen dies aber nicht. Der Sender 17 weist vorteilhaft eine LED 19 auf, wie dies nachfolgend in der Fig. 2 dargestellt ist. Der Empfänger 32 ist nicht im Detail dargestellt, er weist vorteilhaft ein entsprechendes lichtempfindliches Bauteil als Empfangseinrichtung auf, beispielsweise eine Fotozelle oder einen Fototransistor. Die Kochfeldplatte 13 besteht vorteilhaft aus für Kochfelder üblicherweise verwendeter Glaskeramik mit dunkler rotbrauner Einfärbung. Die LED 19 des Senders 17 strahlt vorteilhaft im IR-Bereich aus. So ist einerseits eine gute Durchdringung der Kochfeldplatte 13 möglich und andererseits stört dieses Licht eine Bedienperson nicht. Darüber hinaus ist der Empfänger 32 unempfindlich gegenüber wechselnden sichtbaren Lichtanteilen.

Vom Sender 17 schräg ausgesandte Sender-Lichtstrahlen 30 gehen in diesem schrägen Winkel durch die Kochfeldplatte 13 hindurch. Der Winkel, der hier beispielsweise etwa 23° betragen sollte, ist so gewählt, dass keine Totalreflexion an der Unterseite der Kochfeldplatte 13 erfolgt. Dann treten die Sender-Lichtstrahlen 30 in das Bedienelement 35 an dessen Unterseite ein. Dieses kann zwar grundsätzlich ganz allgemein aus für die Sender-Lichtstrahlen 30 lichtdurchlässigem Material bestehen. Vorteilhaft weist es aber entsprechende Lichtkanäle auf, die besonders vorteilhaft geschlossen sind gegen Eindringen von Schmutz und Wasser.

An der Oberseite des Bedienelements 35, beispielsweise in der Mitte für einen auch beim Drehen gleichbleibenden Bedienort ist ein an sich bekannter Berührungsschalter 36 ausgebildet. Er kann durch eine bestimmte Markierung gekennzeichnet sein. So kann eine Bedienperson instinktiv erkennen, eventuell noch unterstützt durch ein allgemein verständliches Symbol, dass hier ein Finger 37 aufgesetzt werden muss für eine entsprechende Bedienung des Berührungsschalters 36. Dies ist hier der Fall. Aufgrund des speziellen vorgenannten Winkels würden die Sender-Lichtstrahlen 30 an der Oberseite des Bedienelements 35 in im Wesentlichen diesem Winkel austreten und schräg nach oben strahlen. Wegen der zumindest weitgehend oder sogar vollständigen Vermeidung einer Totalreflexion wie gewünscht würden keine Anteile nach unten reflektiert werden. Wird dagegen der Finger 37 auf die Oberseite des Bedienelements 35 bzw. auf den Berührungsschalter 36 aufgelegt, so erfolgt eine solche Reflexion nach unten. Es laufen also die Reflex-Lichtstrahlen 31 nach unten. Hier ist nur der Anteil dargestellt, der dann auch tatsächlich wie vorgesehen auf den Empfänger 32 trifft und dort ausgewertet wird, um zu erfassen, ob durch Auflegen des Fingers 37 der Berührungsschalter 36 bestimmungsgemäß bedient worden bzw. betätigt worden ist. Vor einem vorgenannten lichtempfindlichen Bauteil im Empfänger 32 kann noch eine strahlformende Einrichtung wie beispielsweise eine Linse odgl. vorgesehen sein, dies muss aber nicht so sein.

An dem Bedienelement 35 könnten noch weitere unabhängige Berührungsschalter 36 vorgesehen sein, denen wiederum unter der Kochfeldplatte 13 korrespondierende Paare von Sender und Empfänger zugeordnet sind. Sie funktionieren dann aber nach demselben Prinzip bzw. sind vorteilhaft gleich ausgebildet. Besonders vorteilhaft weisen die jeweiligen Empfänger einen gewissen Abstand zueinander auf oder weisen lichtundurchlässige Abtrennungen auf, um Störungen durch fälschlich abgestrahlte bzw. reflektierte Lichtstrahlen zu vermeiden.

In der Fig. 2 ist im Detail ein möglicher Aufbau für einen Sender 17 samt Mitteln zur Kollimierung bzw. Strahlformung und ein Winkelfilter dargestellt. Er kann natürlich auch in entsprechender Form für einen Empfänger 32 verwendet werden. Im Sender 17 mit einem Sendergehäuse 18 ist eine LED 19 als Sendeeinrichtung angeordnet, vorteilhaft als SMD-LED. In der LED 19 befindet sich ein LED-Chip 20 als aktives Teil, das also tatsächlich das Licht erzeugt und ausstrahlt. Dieser LED-Chip 20 kann beinahe als punktförmige Lichtquelle angesehen werden. Die hier vorgegebenen Abmessungen sind derart, dass die Breite des Sendergehäuses 18 maximal 10 mm betragen kann, die Höhe bei etwa 5 mm bis 6 mm liegt, die Abmessungen der LED 19 sind entsprechend denjenigen einer SMD-LED.

Im Sendergehäuse 18 ist oberhalb von der LED 19 ein sphärischer Reflektor 22 als Mittel zur Kollimierung der Lichtstrahlen vorgesehen bzw. ausgebildet, also nicht nur ein einfach gewölbter. Wenn das Sendergehäuse 18 aus Kunststoff besteht, kann eine Verspiegelung beispielsweise durch Metallbedampfung für den sphärischen Reflektor 22 erfolgen. Der sphärische Reflektor 22 weist einen Brennpunkt 23, zu dem eine Mittelsenkrechte verläuft, links unterhalb der LED 19 auf, er ist also schräggestellt.

Die LED 19 sowie der gesamte Sender 17 sind gemäß der Fig. 2 auf einer Leiterplatte 15 oder einem entsprechenden Träger montiert. Für einen auf diesem Träger angeordneten und die LED 19 umgebenden ebenen Reflektor 25 kann ebenfalls eine Verspiegelung wie zuvor erläutert vorgesehen sein. Alternativ kann eine Verzinnung der Oberfläche des Trägers bzw. der Leiterplatte 15 vorgesehen sein. Alternativ kann ein separates Bauteil vorgesehen sein, beispielsweise eine dünne Metallfolie, ein dünnes Metallplättchen odgl.. Der ebene Reflektor 25 sollte einen entsprechenden, hier nicht dargestellten Ausschnitt rund um die LED 19 aufweisen mit geringem Abstand von beispielsweise 1 mm oder weniger. So können vor allem Verbindungsprobleme und elektrische Probleme vermieden werden.

In der Fig. 2 ist links von dem sphärischen Reflektor 22 als Mittel zur Kollimierung der Lichtstrahlen und dem ebenen Reflektor 25 ein Winkelfilter 27 angeordnet. Dieser Winkelfilter 27 kann beispielsweise eine Wabenstruktur aufweisen und kleine Mikrokanäle 28 enthalten.

Eine Mittelsenkrechte zum Brennpunkt 23 weist einen Winkel α zum ebenen Reflektor 25 und somit auch zum Träger 15für den Sender 17 auf, der hier etwa 67° beträgt. Der Winkelfilter 27 kann in einem Winkel β zum ebenen Reflektor 25 stehen, der ebenfalls 67° beträgt, so dass die Mittelsenkrechte des sphärischen Reflektors 22 etwa parallel ist zur Ebene des Winkelfilters 27. Die Mikrokanäle 28, von denen der unterste des Winkelfilters 27 quasi zu Anschauungszwecken nach links oben stark verlängert dargestellt ist, weisen vorteilhaft alle denselben Winkel innerhalb des Winkelfilters auf. Dieser Winkel γ kann zum ebenen Reflektor 25 ebenfalls etwa 67° betragen, so dass die Mikrokanäle 28 mit einem Winkel von etwa 46° durch den Winkelfilter 27 hindurch verlaufen. Um diese Richtung der Mikrokanäle 28 zu verdeutlichen, ist in starker Verlängerung die strichpunktierte Linie mit der Bezeichnung "23°" eingezeichnet. Dies ist also die Vorzugs-Richtung von Sender-Lichtstrahlen 30, die der Sender 17 aussendet und die in der Fig. 1 auch eingezeichnet sind. Es ist zu erkennen, dass die drei hier dargestellten Lichtstrahlen 30 genau parallel zu dieser Richtung verlaufen. 23° beträgt der Winkel der Richtung der Mikrokanäle 28 zur punktierten vertikalen Achse durch den LED-Chip 20.

Der Winkel von 23° ist derart gewählt, dass die Sender-Lichtstrahlen 30, alternativ auch Reflex-Lichtstrahlen 31, keine Totalreflexion beim Hindurchtritt durch die Kochfeldplatte 13 und/oder das Bedienelement 35 erfahren. Wichtig für die Erfindung ist also zum einen die Kollimierung der Lichtstrahlen und zum anderen das Schrägstellen, so dass eben möglichst viele Lichtstrahlen mit einem Winkel von um die 23°, im Ausführungsbeispiel von 15° bis 34°, erzeugt werden. Diese durchlaufen dann den Winkelfilter 27.

Da auch aufgrund von Einschränkungen bei der Herstellung des Winkelfilters 27 die Mikrokanäle 28 einen gewissen Mindest-Querschnitt aufweisen, der klein sein kann und beispielsweise unter 500 µm liegen kann, beispielsweise 10 µm bis 100 µm betragen kann, ist eine exakte Filterung von Lichtstrahlen auf eine einzige genaue Richtung nicht möglich. Des Weiteren würde dadurch ein zu großer Lichtanteil weggefiltert werden bzw. die Sender-Lichtstrahlen 30 dahinter wären zu schwach. Mit der strichpunktierten Linie rechts oben mit der Bezeichnung "15°" ist dargestellt, mit welchem Winkel zu einer Senkrechten zum ebenen Reflektor 25 minimal die Lichtstrahlen 30 noch durch den Winkelfilter 27 bzw. die Mikrokanäle 28 laufen können wenn sie in der einen Richtung maximal schräg zu den Mikrokanälen 28 verlaufen. Dieser Winkel von 15° zur Senkrechten zum ebenen Reflektor 25 kann nicht unterschritten werden.

In ähnlicher Form ist eine verlängerte strichpunktierte Linie mit der Bezeichnung "34°" eingezeichnet, welche das Maximum für den Winkel der Sender-Lichtstrahlen 30 zur Senkrechten zum ebenen Reflektor 25 darstellt, wenn die Lichtstrahlen 30 also in der anderen Richtung maximal schräg zu den Mikrokanälen 28 verlaufen. Somit können die Sender-Lichtstrahlen 30 quasi in dem Korridor zwischen den strichpunktierten Linien "15°" und "34°" verlaufen. Dies ist zwar keine exakte Gleichrichtung, es ist aber unter praxistauglichen Aspekten sowie aus Kostengründen ein sehr hoher Grad der Gleichrichtung zusätzlich zur vorher erfolgten Kollimierung und wird als ausreichend für die Erfindung angesehen.

Aus der Fig. 2 ist auch noch zu ersehen, dass das Licht stets zuerst von der LED 19 bzw. dem LED-Chip 20 zum sphärischen Reflektor 22 geht, von diesem dann zurückgeworfen wird zum ebenen Reflektor 25 und erst dann zum Winkelfilter 27 geht oder, alternativ, noch einmal zum sphärischen Reflektor 22 und noch einmal zum ebenen Reflektor 25 und dann zum Winkelfilter 27. An dem ganz rechts aus dem Winkelfilter 27 austretenden Sender-Lichtstrahl 30 und seinem Verlauf nach rechts unten ist zu ersehen, dass keine Lichtanteile direkt vom LED-Chip 20 durch den Winkelfilter 27 aus dem Sender 17 heraustreten können. Ebenso sind wegen der Abstrahlrichtung des LED-Chips 20 nach oben auch keine Lichtstrahlen von diesem direkt zum ebenen Reflektor 25 vorhanden.

Es könnten auch vorgenannte sonstige Mittel zur Kollimierung von Lichtstrahlen vorgesehen sein, wie sie zuvor angeführt worden sind, beispielsweise ebenfalls eine Linde oder eine Fresnel-Linse.

Aus der Fig. 2 ist zwar offensichtlich, dass ein Teil des Lichts der LED 19 nicht in dem kollimierten Lichtstrahlbereich der Sender-Lichtstrahlen 30 liegt und somit nicht aus dem Sendergehäuse 18 austreten kann. Die insgesamt auswertbare Lichtmenge durch Auflegen des Fingers 37 auf den Berührungsschalter 36, die also zurückreflektiert wird, ist demzufolge nicht sehr groß. Dafür enthält dieses reflektierte Licht der Reflex-Lichtstrahlen 31 weniger störende Winkelanteile und Totalreflexionsanteile, so dass insgesamt die Auswertung einer Bedienung sicherer und praxistauglicher erfolgen kann. Das ist hier der exemplarischen Konstruktion geschuldet. Durch das Prinzip des Kollimierens kann man eine Lichtausbeute von nahezu 100% erreichen, also des Lichts hinter den Mitteln zur Kollimierung.

## Patentansprüche

1. Kochfeld (10) mit einer Bedieneinrichtung (11) und mit einer Kochfeldplatte (13), wobei
- die Bedieneinrichtung (11) die Kochfeldplatte (13) aufweist, oberhalb derer die Bedienung durch eine Bedienperson erfolgt,
- unterhalb der Kochfeldplatte (13) eine optische Sendeeinrichtung (17) für Lichtstrahlen (30) und eine optische Empfangseinrichtung (32) für Lichtstrahlen (31) sowie optische Umlenkmittel (22) für die Lichtstrahlen (30, 31) zwischen der Unterseite der Kochfeldplatte (13) und der Sendeeinrichtung (17) und/oder der Empfangseinrichtung (32) vorgesehen sind,
- die Lichtstrahlen (30) der Sendeeinrichtung (17) oberhalb von der Kochfeldplatte (13) durch die Bedienperson reflektiert werden mit einem Lichtweg, der erneut durch die Kochfeldplatte (13) und hin zu der Empfangseinrichtung (32) geht,
- die optischen Umlenkmittel ausgebildet sind als Mittel (22) zur Kollimierung von Lichtstrahlen (30),
**dadurch gekennzeichnet,**
- **dass** die Lichtstrahlen (30) der Sendeeinrichtung (17) im Lichtweg hinter den Mitteln (22) zur Kollimierung kollimiert mit demselben Winkel durch die Kochfeldplatte (13) hindurch gehen,
- die Bedieneinrichtung (11) ein Bedienelement (35) aufweist, das auf der Oberseite der Kochfeldplatte (13) drehbeweglich und/oder schiebebeweglich gelagert ist,
- das Bedienelement (35) lichtdurchlässige Lichtkanäle von einer Unterseite an eine Oberseite oder eine Lateralseite aufweist,
- die Lichtstrahlen (30) durch das Bedienelement (35) hindurchgehen.

2. Kochfeld nach Anspruch 1, **dadurch gekennzeichnet, dass** unterhalb der Unterseite der Kochfeldplatte (13) Mittel (25) zum Schrägstellen bzw. schrägen Reflektieren der Lichtstrahlen (30) angeordnet sind, vorzugsweise zwischen den Mitteln (22) zur Kollimierung von Lichtstrahlen (30) und einem Winkelfilter (27), der nur Licht mit einem bestimmten Auftreffwinkel auf den Winkelfilter (27) durchlässt.

3. Kochfeld nach Anspruch 1 oder 2, **dadurch gekennzeichnet, dass** die Mittel (22) zur Kollimierung von Lichtstrahlen (30) und/oder die Mittel (25) zum Schrägstellen bzw. schrägen Reflektieren der Lichtstrahlen (30) nach Anspruch 2 ausgewählt sind aus der folgenden Gruppe: Spiegel, Linse, seitlich versetzte Linse, Prisma, Lichtleiter oder Fresnel-Linse in schräger Anordnung zur Unterseite der Bedienblende.

4. Kochfeld nach Anspruch 3, **dadurch gekennzeichnet, dass** das Schrägstellen bzw. schräge Reflektieren der Lichtstrahlen (30) in einem Winkelbereich zwischen 50° und 80° zur Ebene der Unterseite der Bedienblende (13) erfolgt.

5. Kochfeld nach einem der vorhergehenden Ansprüche, **dadurch gekennzeichnet, dass** als Mittel zur Kollimierung von Lichtstrahlen (30) oberhalb von der Sendeeinrichtung (17) ein gewölbter Reflektor (22) vorgesehen ist zum Spiegeln und Bündeln von auftreffenden Lichtstrahlen (30), wobei unterhalb von der Sendeeinrichtung (17) und/oder der Empfangseinrichtung (32) ein ebener Reflektor (25) vorgesehen ist zum Spiegeln von auftreffenden Lichtstrahlen (30).

6. Kochfeld nach Anspruch 2 und 5, **dadurch gekennzeichnet, dass** seitlich neben der Sendeeinrichtung (17) und/oder der Empfangseinrichtung (32) der Winkelfilter (27) vorgesehen ist, vorzugsweise mit einer Wabenstruktur (28), wobei insbesondere die Lichtstrahlen (30) dahinter durch die Kochfeldplatte (13) hindurchlaufen.

7. Kochfeld nach Anspruch 2 und Anspruch 5 oder 6, **dadurch gekennzeichnet, dass** der Winkelfilter (27) im Weg der Lichtstrahlen (30) nach der Sendeeinrichtung (17), dem gewölbten Reflektor (22) als Mittel zur Kollimierung und dem ebenen Reflektor (25) angeordnet ist und/oder im Weg der Lichtstrahlen vor dem gewölbten Reflektor als Mittel zur Kollimierung, dem ebenen Reflektor und der Empfangseinrichtung angeordnet ist bzw. zwischen Unterseite der Kochfeldplatte (13) und den Reflektoren (25, 27) und der Sendeeinrichtung (17) und/oder der Empfangseinrichtung (32).

8. Kochfeld nach Anspruch 2 und einem der Ansprüche 5 bis 7, **dadurch gekennzeichnet, dass** der ebene Reflektor (25) in einem spitzen Winkel zu dem Winkelfilter (27) steht, vorzugsweise in einem Winkel zwischen 45° und 80°.

9. Kochfeld nach Anspruch 2 und einem der Ansprüche 5 bis 8, **dadurch gekennzeichnet, dass** der ebene Reflektor (25) an den Winkelfilter (27) anstösst.

10. Kochfeld nach Anspruch 2 und einem der Ansprüche 5 bis 9, **dadurch gekennzeichnet, dass** eine Mittelsenkrechte des gewölbten Reflektors (22) in etwa parallel ist zu dem Winkelfilter (27), vorzugsweise mit einer Winkelabweichung zwischen 5° und 10°.

11. Kochfeld nach Anspruch 2 und einem der Ansprüche 5 bis 10, **dadurch gekennzeichnet, dass** der gewölbte Reflektor (22) in einem stumpfen Winkel an den Winkelfilter (27) anstösst, vorzugsweise in einem Winkel zwischen 100° und 130°.

12. Kochfeld nach einem der vorhergehenden Ansprüche, **dadurch gekennzeichnet, dass** die optischen Mittel (22, 27) für die Sendeeinrichtung (17) gleichartig ausgebildet sind wie die optischen Mittel (22, 27) für die Empfangseinrichtung (32), insbesondere identisch.

13. Kochfeld nach einem der vorhergehenden Ansprüche, **dadurch gekennzeichnet, dass** die lichtdurchlässigen Lichtkanäle in einem Mittelbereich des Bedienelements (35) angeordnet sind.

## Claims

1. Cooktop (10) with an operating device (11) and with a cooktop plate (13), wherein
- the operating device (11) includes the cooktop plate (13), above which plate operation by an operator takes place,
- below the cooktop plate (13) an optical transmitter device (17) for beams of light (30) and an optical receiver device (32) for beams of light (31) and optical deflector means (22) for the beams of light (30, 31) between the lower side of the cooktop plate (13) and the transmitter device (17) and/or the receiver device (32) are provided,
- the beams of light (30) of the transmitter device (17) above the cooktop plate (13) are reflected by the operator with a light path which is redirected through the cooktop plate (13) and towards the receiver device (32),
- the optical deflector means are designed as means (22) for collimating of beams of light (30),
**characterized in that**
- the beams of light (30) of the transmitter device (17) in the light path behind the means (22) for collimating pass through the cooktop plate (13) collimated with the same angle,
- the operating device (11) includes an operating element (35) which is mounted on the upper side of the cooktop plate (13) to be rotatable and/or shiftable,
- the operating element (35) includes translucent light channels from a lower side to an upper side or a lateral side,
- the beams of light (30) pass through the operating element (35).

2. Cooktop according to claim 1, **characterized in that** below the lower side of the cooktop plate (13) means (25) for inclining or inclined reflecting of the beams of light (30) are arranged, preferably between the means (22) for collimating of beams of light (30) and an angle filter (27) which permits passing only of light having a certain incident angle on the angle filter (27).

3. Cooktop according to claim 1 or 2, **characterized in that** the means (22) for collimating of beams of light (30) and/or the means (25) for inclining or inclined reflecting of the beams of light (30) according to claim 2 are selected from the following group: mirror, lens, laterally offset lens, prism, light guide or Fresnel lens in inclined arrangement to the lower side of the operator panel.

4. Cooktop according to claim 3, **characterized in that** the inclining or inclined reflecting of the beams of light (30) is in an angular range between 50° and 80° to the plane of the lower side of the operator panel (13).

5. Cooktop according to any one of the preceding claims, **characterized in that** a curved reflector (22) is provided as means for collimating of beams of light (30) above the transmitter device (17) for reflecting and combining of incident beams of light (30), wherein below the transmitter device (17) and/or the receiver device (32) a planar reflector (25) is provided for reflecting of incident beams of light (30).

6. Cooktop according to claim 2 and 5, **characterized in that** laterally besides the transmitter device (17) and/or the receiver device (32) the angle filter (27) is provided, preferably having a honeycomb structure (28), wherein in particular the beams of light (30) pass through the cooktop plate (13) behind it.

7. Cooktop according to claim 2 and claim 5 or 6, **characterized in that** the angle filter (27) is arranged in the path of the beams of light (30) after the transmitter device (17), the curved reflector (22) as a means for collimating and the planar reflector (25), and/or is arranged in the path of the beams of light before the curved reflector as a means for collimating, the planar reflector and the receiver device or between lower side of the cooktop plate (13) and the reflectors (25, 27) and the transmitter device (17) and/or the receiver device (32).

8. Cooktop according to claim 2 and any of claims 5 to 7, **characterized in that** the planar reflector (25) is at an acute angle to the angle filter (27), preferably at an angle between 45° and 80°.

9. Cooktop according to claim 2 and any of claims 5 to 8, **characterized in that** the planar reflector (25) abuts on the angle filter (27).

10. Cooktop according to claim 2 and any of claims 5 to 9, **characterized in that** a perpendicular bisector of the curved reflector (22) is approximately parallel to the angle filter (27), preferably with an angular deviation between 5° and 10°.

11. Cooktop according to claim 2 and any of claims 5 to 10, **characterized in that** the curved reflector (22) abuts at an obtuse angle on the angle filter (27), preferably at an angle between 100° and 130°.

12. Cooktop according to any one of the preceding claims, **characterized in that** the optical means (22, 27) for the transmitter device (17) have a design similar to that of the optical means (22, 27) for the receiver device (32), in particular are identical.

13. Cooktop according to any one of the preceding claims, **characterized in that** the translucent light channels are disposed in a central region of the operating element (35).

## Revendications

1. Table de cuisson (10) avec un dispositif de commande (11) et avec une plaque de table de cuisson (13), dans laquelle
- le dispositif de commande (11) présente la plaque de table de cuisson (13), au-dessus de laquelle la commande est effectuée par un opérateur,
- au-dessous de la plaque de table de cuisson (13) sont prévus un dispositif de transmission optique (17) pour rayons de lumière (30) et un dispositif de réception optique (32) pour rayons de lumière (31) ainsi que moyens de déviation optiques (22) pour les rayons de lumière (30, 31) entre le côté inférieur de la plaque de table de cuisson (13) et le dispositif de transmission (17) et/ou le dispositif de réception (32),
- les rayons de lumière (30) du dispositif de transmission (17) au-dessus de la plaque de table de cuisson (13) sont réfléchis par l'opérateur d'un chemin optique passant une nouvelle fois à travers la plaque de table de cuisson (13) et vers le dispositif de réception (32),
- les moyens de déviation optiques sont configurés sous forme de moyens (22) pour collimater des rayons de lumière (30),
**caractérisée en ce que**
- les rayons de lumière (30) du dispositif de transmission (17) dans le chemin optique derrière les moyens (22) pour collimater passent à travers la plaque de table de cuisson (13) collimatés selon un même angle,
- le dispositif de commande (11) présente un élément de commande (35) supporté de manière rotative et/ou déplaçable sur le côté supérieur de la plaque de table de cuisson (13),
- l'élément de commande (35) présente des canaux de lumière translucides d'un côté inférieur à un côté supérieur ou un côté latéral,
- les rayons de lumière (30) passent à travers l'élément de commande (35).

2. Table de cuisson selon la revendication 1, **caractérisée en ce que**, au-dessous du côté inférieur de la plaque de table de cuisson (13), moyens (25) pour l'inclinaison ou réflexion inclinée des rayons de lumière (30) sont agencés, de préférence entre les moyens (22) pour collimater des rayons de lumière (30) et un filtre d'angle (27), permettant le passage seulement de lumière d'un certain angle d'incidence sur le filtre d'angle (27).

3. Table de cuisson selon la revendication 1 ou 2, **caractérisée en ce que** les moyens (22) pour collimater des rayons de lumière (30) et/ou les moyens (25) pour l'inclinaison ou réflexion inclinée des rayons de lumière (30) selon la revendication 2 sont sélectionnés du groupe suivant : miroir, lentille, lentille décalée latéralement, prisme, conducteur optique ou lentille Fresnel dans un arrangement incliné par rapport au côté inférieur du panneau de commande.

4. Table de cuisson selon la revendication 3, **caractérisée en ce que** l'inclinaison ou la réflexion inclinée des rayons de lumière (30) se fait dans une plage angulaire entre 50° et 80° par rapport au plan du côté inférieur du panneau de commande (13).

5. Table de cuisson selon l'une des revendications précédentes, **caractérisée en ce qu'**en tant que moyens pour collimater des rayons de lumière (30) au-dessus du dispositif de transmission (17) un réflecteur courbé (22) est agencé pour miroiter et converger des rayons de lumière (30) incidents, dans laquelle un réflecteur plan (25) est agencé en dessous du dispositif de transmission (17) et/ou du dispositif de réception (32) pour miroiter des rayons de lumière (30) incidents.

6. Table de cuisson selon la revendication 2 et 5, **caractérisée en ce que** latéralement à côté du dispositif de transmission (17) et/ou du dispositif de réception (32) le filtre d'angle (27) est prévu, de préférence présentant une structure alvéolaire (28), dans laquelle en particulier les rayons de lumière (30) passent à travers la plaque de table de cuisson (13) en arrière.

7. Table de cuisson selon la revendication 2 et la revendication 5 ou 6, **caractérisée en ce que** le filtre d'angle (27) est arrangé dans le chemin des rayons de lumière (30) après le dispositif de transmission (17), le réflecteur courbé (22) en tant que moyens pour collimater et le réflecteur plan (25) et/ou est arrangé dans le chemin des rayons de lumière avant le réflecteur courbé en tant que moyens pour collimater, le réflecteur plan et le dispositif de réception ou entre le côté inférieur de la plaque de table de cuisson (13) et les réflecteurs (25, 27) et le dispositif de transmission (17) et/ou le dispositif de réception (32).

8. Table de cuisson selon la revendication 2 et l'une des revendications 5 à 7, **caractérisée en ce que** le réflecteur plan (25) se situe dans un angle aigu par rapport au filtre d'angle (27), de préférence dans un angle entre 45° et 80°.

9. Table de cuisson selon la revendication 2 et l'une des revendications 5 à 8, **caractérisée en ce que** le réflecteur plan (25) touche au filtre d'angle (27).

10. Table de cuisson selon la revendication 2 et l'une des revendications 5 à 9, **caractérisée en ce qu'**une médiatrice du réflecteur courbé (22) se situe approximativement parallèle au filtre d'angle (27), de préférence avec une déviation angulaire entre 5° et 10°.

11. Table de cuisson selon la revendication 2 et l'une des revendications 5 à 10, **caractérisée en ce que** le réflecteur courbé (22) touche au filtre d'angle (27) dans un angle obtus, de préférence dans un angle entre 100° et 130°.

12. Table de cuisson selon l'une des revendications précédentes, **caractérisée en ce que** les moyens optiques (22, 27) pour le dispositif de transmission (17) présentent une configuration similaire à celle des moyens optiques (22, 27) pour le dispositif de réception (32), en particulier sont identiques.

13. Table de cuisson selon l'une des revendications précédentes, **caractérisée en ce que** les canaux de lumière translucides sont arrangés dans une zone centrale de l'élément de commande (35).
